# EUROPÄISCHE PATENTSCHRIFT

(11) **EP 2 785 764 B1**
(45) Veröffentlichungstag und Bekanntmachung des Hinweises auf die Patenterteilung: **12.10.2016**
(21) Anmeldenummer: 12794690.3
(22) Anmeldetag: 23.11.2012
(51) Int. Cl.: B32B 15/08, B32B 27/36

(54) **METALLISIERTER MEHRSCHICHTKÖRPER AUS SPEZIELLEN POLYCARBONATEN MIT NIEDRIGEM WÄRMEAUSDEHNUNGSKOEFFIZIENT**
METALLISED MULTILAYER BODY MADE OF SPECIAL POLYCARBONATES WITH LOW THERMAL EXPANSION COEFFICIENT
CORPS MULTICOUCHE MÉTALLISÉ EN POLYCARBONATES SPÉCIAUX AYANT UN COEFFICIENT DE DILATATION THERMIQUE BAS

(30) Priorität: 30.11.2011 EP 11191319
(43) Veröffentlichungstag der Anmeldung: 08.10.2014
(73) Patentinhaber: Covestro Deutschland AG, 51373 Leverkusen (DE)
(72) Erfinder: MEYER, Alexander, 40489 Düsseldorf (DE); DÖBLER, Martin, 40593 Düsseldorf (DE); GROSSER, Ulrich, 51515 Kürten (DE); OSER, Rafael, 47800 Krefeld (DE); SÄMISCH, Birte, 50670 Köln (DE); THULKE, Thomas, 50733 Köln (DE)
(74) Vertreter: Levpat
(86) Internationale Anmeldenummer: PCT/EP2012/073428
(87) Internationale Veröffentlichungsnummer: WO 2013/079398

(56) Entgegenhaltungen:
- US-A1- 2004 063 031
- KLAUS HORN ET AL: "Polycarbonat (PC)", KUNSTSTOFFE, Oktober 2005 (2005-10), Seiten 90-98, XP009158987,
- anonymous: "Headlamp bezels and appliance parts for the Golf A5 in Apec(R)", , XP002675318, Gefunden im Internet: URL:http://plastics.bayer.com/plastics/eme a/en/product/apec/application_areas/docId- 72232/Headlamp_bezels_for_the_Golf_V.html [gefunden am 2012-05-02]

## Beschreibung

Die Erfindung betrifft Mehrschichtkörper aus wenigstens einem thermoplastischen Material, welche mindestens eine Metallschicht aufweisen. Desweiteren betrifft die Erfindung mehrschichtige Erzeugnisse umfassend mindestens drei Schichten enthaltend eine Substratschicht aus einem Substrat enthaltend spezielle Copolycarbonate sowie mindestens einen speziellen anorganischen Füllstoff, eine Metallschicht und eine oder mehrere weitere Schicht(en). Ferner ist das Verfahren zur Herstellung dieser Mehrschichtkörper Gegenstand der Erfindung.

Polycarbonate werden aufgrund ihrer hohen Wärmeformbeständigkeit u. a. in Bereichen eingesetzt, in denen mit einer erhöhten Temperaturbelastung zu rechnen ist. Mit speziellen Copolycarbonaten (wie z.B. bei einem Copolycarbonat basierend auf Bisphenol A und Bisphenol TMC (1,1-Bis-(4-hydroxyphenyl)-3,3,5-trimethylcyclohexan)) gelingt es, die Wärmeformbeständigkeit weiter zu erhöhen. Diese Polycarbonate eignen sich daher auch zur Herstellung von Linsen, Reflektoren, Lampenabdeckungen und -gehäusen etc., die einer höheren Temperaturbelastung ausgesetzt sind. Bei diesen Anwendungen sind praktisch immer erhöhte thermische Eigenschaften wie hohe Vicat-Erweichungstemperatur (Wärmeformbeständigkeit) bzw. hohe Glastemperatur in Kombination mit ausreichenden mechanischen Eigenschaften zwingend gefordert.

Copolycarbonate aus Bisphenol A und Bisphenol TMC sind unter dem Handelsnamen Apec® von Bayer Materialscience AG kommerziell erhältlich.

Neben einer guten Verarbeitbarkeit und guten mechanischen Eigenschaften müssen diese Materialien auch weiteren Anforderungen wie einer guten Oberflächenqualität im resultierenden Spritzgussteil / Extrudat sowie einer guten Metallhaftung genügen.

Je nach eingesetzten Bisphenolen und geeigneter Einstellung des Molekulargewichts der Copolycarbonate lassen sich die Wärmeformbeständigkeit und die mechanischen Eigenschaften in einem weiten Bereich variieren.

Im Bereich der Reflektoranwendungen ist neben einer guten Metallhaftung häufig auch eine geringe Wärmeausdehnung gefordert bzw. von Vorteil, da eine hohe Wärmeausdehnung sich nachteilig auf Lichtbündelung und Lichtausbeute auswirken kann. Der Reflektor ist meist in direkter Umgebung der Lichtquelle, z.B. einer Glühlampe angeordnet, welche häufig eine hohe Wärmeabstrahlung aufweist. Damit ist der Reflektor einer hohen Wärmebelastung - häufig von über 160 °C - ausgesetzt. Aus diesem Grund ist es also nötig, ein Material mit einem möglichst niedrigen linearen thermischen Ausdehnungskoeffizienten einzusetzen. Darüber hinaus soll das Material in einem weiten Temperaturbereich insbesondere auch bei Temperaturen oberhalb von 160 °C formstabil sein, d.h. das Ausdehnungs- und Schwindungsverhalten muss möglichst isotrop sein, um wie oben beschrieben optische Verzerrungen bei der Reflektoranwendung zu vermeiden. Bevorzugt weist die Metallschicht des Mehrschichtartikels ein ähnliches Ausdehnungsverhalten und Schwindungsverhalten wie die Basisschicht auf, da es sonst in Folge von Spannungen es zu Verwerfungen an der Oberfläche und somit zu Irisierungsphänomenen kommen kann. Durch die Anpassung des Wärmeausdehnungsverhaltens werden somit Oberflächenstörungen wie Rissbildung, Irisierung und Stauchung reduziert.

Zur Abdeckung von Reflektoren im Automobilbereich sind heute häufig profilose Klarsichtscheiben aus Polycarbonat im Einsatz. Dies erhöht die Anforderungen an die Oberflächengüte der von außen gut sichtbaren Elemente (z. B. Reflektor, Subreflektor, Blendrahmen), wobei die Dimensionsbeständigkeit in der Wärme, ein geringes Ausgasen um Blasenbildung zu vermeiden, die mechanische Festigkeit, eine einfache Verarbeitung und geringe Fertigungstoleranzen weiterhin wichtig sind.

Das Material für die Basisschicht soll sich bevorzugt im Spritzguss verarbeiten lassen und gegenüber anderen Thermoplasten mit Vicat-Erweichungstemperaturen von größer 160 °C verhältnismäßig preiswert sein.

Wie oben beschrieben müssen die entsprechenden metallisierten Teile eine hohe Temperaturbeständigkeit aufweisen. So dürfen weder die mechanischen Eigenschaften noch die optischen Eigenschaften wie z.B. die Qualität der Metalloberfläche abnehmen. Es zeigte sich jedoch, dass metallisierte Formkörper aus bestimmten Thermoplasten darunter auch Copolycarbonate, welche Vicat-Erweichungstemperaturen von mehr als 160 °C, insbesondere mehr als 170 °C, aufweisen und welche u.a. 1,1-Bis-(4-hydroxyphenyl)-cyclohexan-Derivate enthalten, für spezielle Anwendungen eine oftmals nicht ausreichende optische Qualität bei sehr hohen Temperaturen aufweisen. So neigen derartige Formkörper, die unter speziellen Bedingungen, insbesondere unter Plasma-Bedingungen, metallisiert und vorbehandelt wurden, unter speziellen Bedingungen zu Blasenbildung (Blasen- und Rissbildung der Beschichtung) bei hohen Temperaturen (insbesondere bei Temperaturen oder Temperaturspitzen von größer 170 °C). Dies kann zum Ausfall des entsprechenden Formköpers in der jeweiligen Anwendung führen. Durch die Blasenbildung verliert die Metalloberfläche ihr einheitliches Aussehen - ferner wird die Reflexion von Licht negativ beeinflusst.

Weiterhin war überraschend, dass nicht jedes Metallisierungsverfahren zu einer Schädigung der Oberfläche unter Wärmebelastung führt. Wenn das entsprechende Metall nur aufgedampft und dabei das Substrat keinem Ionenbeschuß wie es in eine niederfrequenten Plasmavorbehandlung oder dem DC-sputtern der Fall ist ausgesetzt wird, ist der Polymer-Metallverbund sehr stabil und zeigt auch unter Wärmebelastung keine Ausbildung von Oberflächenstörungen. Die Oberflächenstörungen treten dann auf, wenn die Spritzgussteile im Plasma in einem DC-Sputterprozess beschichtet wurden. Aber auch hier führt nicht jedes Plasma-gestützte Verfahren zu einer anschließenden Oberflächenstörung. So muss noch ein weiterer niederfrequenter Plasmaschritt wie z.B. eine Plasmavorbehandlung geschehen. In diesem Verfahrenschritt wird mittels Plasma die Oberfläche von Verunreinigungen befreit und das Polymer für den anschließenden Metallauftrag ggf. aktiviert oder die Abscheidung des Top Coats. Dieser Schritt ist aufgrund des Reinigungs- und Aktivierungseffektes der Oberfläche in einem industriellen Prozess unerlässlich. Aus Gründen der Wirtschaftlichkeit soll sich der erfindungsgemäße Mehrschichtkörper in einem DC-Sputterprozess beschichten lassen - dies setzt voraus, dass sich das Substratmaterial für diese Beschichtungsmethode eignet.

Mit Oberflächenstörungen nach Wärmebelastung sind wie oben beschrieben vor allem Blasen, welche eine Zerstörung der metallischen Oberfläche zur Folge haben, gemeint. Darüber hinaus kann es zur Ausbildung einer eingetrübten Metalloberfläche nach Wärmebelastung kommen. Ferner kann als Fehler eine Irisierung der Oberfläche nach Wärmebelastung auftreten. Alle diese Fehler treten nur auf, wenn der metallisierte Körper einer Wärmebelastung unterzogen wird - es ist also vorher, d.h. direkt nach der Metallisierung, nicht zu erkennen, ob ein metallisierter Formkörper Oberflächenfehler ausbilden wird.

Bisher wurden zum Herstellen von Reflektoren zumeist Duroplaste, seltener auch Thermoplaste eingesetzt. Von den letzteren weisen die hauptsächlich verwendeten amorphen Thermoplaste, z.B. Polyetherimid (PEI), Polyamidimid (PAI) oder Polysulfone, z.B. Polyethersulfon (PES) bzw. Polysulfon (PSU) bzw. Polyphenylenethersulfon (PPSU), eine hohe bis sehr hohe Vicat-Erweichungstemperatur bzw. Glastemperatur (Tg) auf. Diese amorphen IIoch-Tg-Thermoplaste können ohne Füllstoffe zum Erzeugen von Reflektor-Rohlingen mit einer hervorragenden Oberflächenglätte verwendet werden. Die Reflektor-Rohlinge können direkt metallisiert werden. Nachteilig für eine Massenproduktion ist allerdings der zum Teil sehr hohe Preis der genannten amorphen Hoch-Tg-Thermoplaste. Zudem gestaltet sich die Verarbeitung dieser Hoch-Tg-Thermoplaste zum Teil als schwierig. Ferner weisen Sie z.T. Wärmeausdehnungskoeffizienten auf, die für anspruchsvolle Reflektorgeometrien zu hoch sind.

Für Scheinwerferreflektoren kommen hauptsächlich Bulk Molding Compounds (BMC) zur Anwendung. Dabei handelt es sich um ein Faser-Matrix-Halbzeug. Es besteht zumeist aus Kurz-Glasfasern und einem Polyester- oder Vinylesterharz, andere Verstärkungsfasern oder Harzsysteme sind möglich. BMC wird im Heisspressverfahren verarbeitet, was kurze Taktzeiten ermöglicht. Die BMC Masse wird dazu zentral in ein beheiztes, geteiltes Werkzeug eingelegt. Beim Schliessen verteilt sich das BMC im Werkzeug. Durch die kurzen Faserlängen können beim Pressen auch dünne Rippen und Wanddicken gefüllt werden. Es besteht jedoch die Gefahr, dass sich an Engstellen das BMC entmischt. Dies geschieht dann, wenn eine Engstelle mit Fasern verstopft, so dass nur noch das Harz weiterfliessen kann. Die einzelnen Verstärkungsfasern orientieren sich in der Regel in Strömungsrichtung, so dass lokal stark orientierte Fasern auftreten können. In Spezialverfahren kann BMC, bei entsprechend kleinen Faserlängen, auch im Spritzgussverfahren verarbeitet werden.

Eine typische Anwendung für Duroplaste (BMC) sind PKW-Scheinwerfer, genauer die Reflektoren des Scheinwerfers. Hier kommt die gute Masshaltigkeit und Temperaturbeständigkeit zum Tragen. Der Prozess ähnelt sehr stark dem Elastomer-Spritzgiessen. Die Zykluszeiten sind bei der Duroplastverarbeitung in der Regel bei Wanddicken bis ca. 4 mm länger als bei Thermoplasten. Dadurch verlieren Duroplaste im Wirtschaftlichkeitsvergleich meist gegenüber den Thermoplasten, wenn die guten elektrischen oder mechanischen Eigenschaften nicht benötigt werden. Für die Metallisierung dieser Duroplaste müssen weitere Fertigungschritte wie z.B. Polieren und Lackieren erfolgen, was die Wirtschaftlichkeit gegenüber direkt metallisierbare Thermoplaste weiter verschlechtert.

Füllstoffe haben dabei überwiegend die Aufgabe das BMC kostengünstiger herzustellen, indem Faser- und Harzvolumen durch billigere Füllstoffe ersetzt wird. Je nach gewünschten Eigenschaften, zum Beispiel erhöhter Flammschutz oder niedriger Schrumpf, werden Zusatzstoffe zugesetzt. So erhöht zum Beispiel Magnesiumoxid die Plastizität und Kaolin die Säurebeständigkeit.

In der Beleuchtungseinheit treten naturgemäß die höchsten Temperaturen auf. Daher wurden bisher die Reflektoren entweder aus Blech, aus Duroplasten, wie BMC oder aus metallisierten, spritzgegossenen amorphen Hoch-Tg-Thermoplasten (PEI, PSU, PES) hergestellt. Die hohen Toleranzanforderungen, gekoppelt mit der für die Metallisierung erforderlichen Oberflächengüte der Spritzgussteile, wurden bisher hauptsächlich von ungefüllten amorphen Hoch-Tg-Thermoplasten oder lackierten Duroplasten erfüllt.

Eine weitere Anforderung betrifft die Oberflächengüte der zu beschichtenden (meist gekrümmten) Kunststoffoberfläche. Speziell bei Reflektoren, bei welchen die Lichtausbeute essentiell ist, muss eine möglichst homogene, sehr glatte, hochglänzende Oberfläche für die Beschichtung bereitgestellt werden. Schlecht fließende oder zu früh erstarrende Kunststoffe bzw. eine Zugabe von Füllstoffen führen in der Spritzgussform oft zu einem rauen, matten oder unregelmäßigen Abdruck, gemessen an den extrem hohen Anforderungen einer spiegelglatten Oberfläche, selbst wenn die entsprechende Oberfläche des formgebenden Werkzeugs hochglanzpoliert ist.

Die im europäischen Patent EP 725 101 B2 offenbarten transparenten, farblosen und amorphen Homopolyamide weisen eine Glastemperatur von ca. 157 °C auf und sind allenfalls für die Herstellung von Subreflektoren, aber nicht für die Herstellung von Lichtreflektierbauteilen geeignet, die für höhere Betriebstemperaturen ausgelegt sind.

Aus dem Patent US 6,355,723 B1 sind spritzgegossene Reflektoren aus amorphen Thermoplasten, wie Polyetherimiden, Polyarylethern, Polyethersulfonen, Polysulfonen, Polycarbonaten, Polyestercarbonaten, Polyarylaten, Polyamiden, Polyestern und Einzelphasengemischen solcher Thermoplaste bekannt. Diese Reflektoren können direkt mit einer Metallschicht versehen werden und eine Glasübergangstemperatur (Tg) von mindestens 170 °C bis 200 °C aufweisen. Um auffällige Oberflächenfehler vor dem Metallisieren der Reflektoroberfläche mittels Sichtinspektion einfacher feststellen zu können und um unerwünschte Lichteffekte durch nicht-metallisierte Teile der Reflektoren zu unterbinden, sind alle diese Reflektoren mittels Beimischen von Farbstoffen schwarz eingefärbt. Diese Materialien und Formteile weisen allerdings nicht die gewünschten niedrigen Wärmeausdehnungskoeffizienten auf und sind teilweise für die gewünschte Anwendung zu teuer.

Generell haben die im Stand der Technik vorbeschriebenen Polycarbonate bzw. Copolycarbonate durch ihre zu hohen Ausdehnungskoeffizienten den Nachteil, dass sie beim Einsatz als metallisiertes Bauteil bei z. B. Hochtemperaturanwendungen als Reflektor nur beschränkt oder gar nicht geeignet sein können.

Polyimide weisen z.T. sehr hohe Glastemperaturen auf in Kombination mit sehr geringen thermischen Ausdehnungskoeffizienten - sie erscheinen jedoch orange bis braun im optischen Aussehen. Die Kosten für diese Materialien sind ebenfalls sehr hoch. Ein Polymermaterial, welches zu vertretbaren Kosten bei gleichzeitiger hoher Glastemperatur, geringer thermischen Ausdehnung eine hohe optische Oberflächengüte wäre für Reflektoren wünschenswert.

Der Auftrag von Metallen auf das Polymer kann über verschiedene Methoden wie z.B. durch Aufdampfen oder Sputtern geschehen. Die Verfahren sind näher beschrieben z.B. in "Vakuumbeschichtung Bd.1 bis 5", H. Frey, VDI-Verlag Düsseldorf 1995 oder "Oberflächen- und Dünnschicht-Technologie" Teil 1, R.A. Haefer, Springer Verlag 1987.

Um eine bessere Metallhaftung zu erreichen und um die Substratoberfläche zu reinigen, werden die Substrate normalerweise einer Plasmavorbehandlung unterzogen. Eine Plasmavorbehandlung kann u. U. die Oberflächeneigenschaften von Polymeren verändern. Diese Methoden sind z.B. bei Friedrich et al. in Metallized Plastics 5&6: Fundamental and applied aspects und H. Grünwald et al. In Surface and Coatings Technology 111 (1999) 287-296 beschrieben.

Weitere Schichten wie korrosionsmindernde Schutzschlichten kann in einem PECVD (Plasma Enhanced Chemical Vapour Deposition) oder Plasmapolymerisationsprozess aufgebracht werden. Hierbei werden niedrigsiedende Precursoren haupsächlich auf Siloxan-Basis in ein Plasma verdampft und dadurch aktiviert, so dass sie einen Film bilden können. Typsiche Substanzen hierbei sind Hexamethyldisiloxan (HMDSO), Tetrametyldisiloxan, Decamethylcyclopentasiloxan, Octamethylcyclotetrasiloxan und Trimethoximethylsilan.

Copolycarbonate basierend auf Cycloalkylidendiphenolen sind bekannt und in verschiedenen Publikationen beschrieben worden.

So beschreiben die DE 3 903 103 A1, EP 414 083 A2 und die EP 359 953 A1 die Herstellung und Verwendung von Polycarbonaten auf Basis von Cycloalkylidendiphenolen.

Auch eine Reihe von Zusammensetzungen enthaltend Copolycarbonate mit Cycloalkylidendiphenolen und verschiedene weitere polymere Komponenten sind beschrieben worden.

In dem Dokument "Polycarbonat (PC)", Kunststoffe, Oktober 2005 (2005-10), Seiten 90 bis 98 wird ein Zweischichtenkörper enthaltend eine ungefüllte Substratschicht aus Apec und eine mit dieser Schicht verbundene Metallschicht offenbart.

Die US 2004/063031 A1 offenbart die Verwendung von anorganischen Füllstoffen wie Talk, Glimmer und Ton in thermoplastischen Polymeren.

Keine dieser Anmeldungen beschäftigt sich jedoch mit verbesserten optischen Eigenschaften an metallisierten Formkörpern bei Temperaturen oberhalb 160°C bzw. oberhalb von 170 °C. Es werden ebenfalls keine Materialien mit niedrigem thermischen Ausdehnungskoeffizienten beschrieben. Aus dem bisherigen Stand der Technik ist nicht ersichtlich, wie das oben beschriebene Problem zu lösen ist.

Es bestand daher die Aufgabe, einen Mehrschichtkörper mit hochreflektierender Oberfläche zur Verfügung zu stellen, welcher einen linearen Wärmeausdehnungskoeffizienten nach ASTM E 831. von weniger als 58 x10⁻⁶/K, bevorzugt weniger als 55x10⁻⁶/K , besonders bevorzugt weniger als 53 x 10⁻⁶/K, insbesondere bevorzugt weniger als 50x10⁻⁶/K (in längs und quer-Richtung) aufweist und eine Oberfläche mit einem Glanzgrad (Gloss) von mindestens 800 (20° Einfallswinkel und Ausfallswinkel) bevorzugt größer 1000 (20° Einfallswinkel und Ausfallswinkel) gemessen nach ASTM D523 aufweist. Die Oberfläche soll dabei die fehlerfreien, hochglänzen Eigenschaften auch bei hohen Temperaturen über einen längeren Zeitraum beibehalten (Thermostabilität).

Ferner soll der Mehrschichtkörper aus einem Substratmaterial bestehen (Basisschicht), welches eine hohe Schmelzestabilität aufweist, da es bei der Verarbeitung von Thermoplasten mit hoher Vicat-Erweichungstemperatur zu vergleichsweise hohen thermischen Belastungen kommen kann. Weiterhin soll das Substratmaterial preislich günstiger als gängige Polyetherimid, Polysulfon bzw. Polyethersulfon basierende Materialien sein.. Weiterhin soll die Basisschicht ein möglichst isotropes Verhalten bezüglich der Wärmeausdehnung aufweisen. So soll die Wärmeausdehnung in längs-Richtung um nicht mehr als 25 %, bevorzugt nicht mehr als 20%, besonders bevorzugt nicht mehr als 15% vom entsprechenden Wert in quer-Richtung abweichen bzw. umgekehlt. Die Basisschicht muss dabei eine hohe Wärmeformbeständigkeit, d.h. eine Glastemperatur bzw. Vicat-Erweichungstemperatur von mehr als 160 °C aufweisen.

In einer besonders bevorzugten Ausführungsform soll der Reflektor eine hohe thermische Leitfähigkeit besitzen, um die bei Reflektoren häufig auftretende Wärmebelastung durch eine entsprechend hohe Wärmeleitfähigkeit zu minimieren. So soll die thermische Leitfähigkeit in einer besonderen Ausführungsform mehr als 0,3 W/mK, bevorzugt mehr als 0,4 W/mK, betragen.

Ferner muss zur Herstellung des erfindungsgemäßen Mehrschichtkörpers die Substratschicht in einem speziellen Verfahren beschichtet werden, um die guten Reflexionseigenschaften auch unter hohen Temperaturen zu erhalten.

Ferner muss ein entsprechender Formkörper (Substratmaterial; Basisschicht) in einem Spritzgussverfahren bzw. Thermoformverfahren bei Werkzeugtemperaturen von größer 160°C erzeugt werden, um eine Defektstellen-freie Oberfläche zu erzeugen. Prinzipiell sind die Methoden zur Herstellung von hochqualitativen Oberflächen bei hohen Werkzeugtemperaturen bekannt, jedoch ist es dem Fachmann nicht bekannt, welche Substratmaterialien sich für ein derartiges Verfahren und darüber hinaus für die Herstellung metallisierter Mehrschichtkörper eignen.

Überraschenderweise konnte das Problem gelöst werden, indem ein Substratmaterial aus speziellen Copolycarbonaten in Verbindung mit speziellen Füllstoffen verwendet wurde. Dabei zeigte sich, dass spezielle anorganische Partikel mit sphärischer bzw. plättchenförmiger Geometrie, welche ausgewählt sind aus der Gruppe bestehend aus Nitriden, Oxiden, Mischoxiden, Carbiden, gepulvertem Quarz, SiO₂-Partikeln, amorphem SiO₂, gemahlenem Sand, Glaspartikeln, Glasvollkugeln und synthetischem Graphit für die Lösung der Aufgabe geeignet sind. Insbesondere bevorzugt sind dabei Substratmaterialien enthaltend zumindest zu 60 Gew.-% Copolycarbonate auf Basis von 1,1-Bis-(4-hydroxyphenyl)-cyclohexan-Derivaten.

Die Aufgabe wurde erfindungsgemäß durch einen Mehrschichtkörper gelöst, welcher folgenden Aufbau hat:
- eine Basisschicht a)
- eine Metallschicht b)
- eine oder mehrere Schichten c)
- optional eine oder mehrere weitere Schichten
   a) Basisschicht bestehend aus einem Copolycarbonat mit einer Vicat-Erweichungstemperatur von mehr als 160 °C. Bevorzugt besteht dabei das Substratmaterial aus Copolycarbonaten mit einer Vicat-Erweichungstemperaturen von größer als 160 °C bevorzugt von größer als 165 °C insbesondere bevorzugt größer als 170 °C enthaltend als Kettenabbrecher (Endgruppe) eine Struktureinheit der Formel (1) 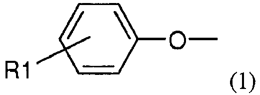 in der
      R1 für Wasserstoff oder C₁-C₁₈-Alkyl stehen; ganz besonders bevorzugt sind als Kettenabbrecher Phenol oder tert.-Butylphenol oder n-Butylphenol, insbesondere Phenol und p-tert. Butylphenol,
      und mindestens ein Diphenolbaustein der Formel (2) enthält, 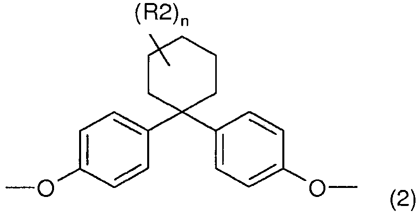 in der
      R2 für C₁-C₄-Alkyl (hiermit ist Methyl, Ethyl-, Propyl, Isopropyl- und Butyl sowie Isobutylreste umfasst), bevorzugt Methyl,
      n für 0, 1, 2 oder 3, bevorzugt 2 oder 3 stehen,
      sowie einen oder mehrere anorganische Füllstoffe mit sphärischer oder Plättchengeometrie zu 5 bis 50 Gew.-%, bevorzugt 10 Gew.-% - 40 Gew.-% insbesondere bevorzugt zu 15 Gew.-% -35 Gew.-%, bezogen auf die die Summe eingesetzter Thermoplaste, enthält, wobei der Füllstoffe ausgewählt ist aus der Gruppe bestehend aus Nitriden, Oxiden, Mischoxiden, Carbiden, gepulvertem Quarz, SiO₂-Partikeln, amorphem SiO₂, gemahlenem Sand, Glaspartikeln, Glasvollkugeln und synthetischem Graphit; dabei weist die Schicht a) eine Schichtdicke von 0,1 mm bis 6,0 mm bevorzugt 0,2 mm bis 5,0 mm und besonders bevorzugt 0,5 mm bis 4,0 mm auf
   b) eine Metallschicht aus Aluminium, Silber, Chrom, Titan, Palladium, bevorzugt aus Silber oder Aluminium, insbesondere bevorzugt Aluminium mit einer Dicke der Metallschicht beträgt bevorzugt 10 nm - 1000 nm, bevorzugt 50 nm - 800 nm insbesondere bevorzugt 60 nm - 500 nm und ganz besonders bevorzugt 60 nm - 300 nm. Bevorzugt wird diese Metallschicht in einem Plasmaverfahren hergestellt, und
   c) optional eine Schutzschicht (nachfolgend auch Top Coat genannt) aus Polysiloxan bevorzugt hergestellt in einem Plasmaprozess mit Hexamethyldisiloxan (CAS 107-46-0) als Beschichtungsmaterial. Die Schichtdicke des Top Coats beträgt 10 nm - 200 nm bevorzugt 20 nm - 100 nm.

In einer weiteren speziellen Ausführungsform kann weiterhin eine Schicht enthalten sein, die eine Kondensatbildung auf der Oberfläche verhindert.

Der Metallisierungsprozess umfasst drei Prozessschritte:
1. Plasmavorbehandlung
2. Metallisierung
3. Abscheidung einer Korrosionsschutzschicht

Die Metallschicht wird typischerweise aufgedampft oder DC-gesputtert (Kathodenzerstäubung über Gleichspannungsplasma). Für Schritt 1 und 3 werden typischerweise dieselben technischen Einrichtungen verwendet. Dies ist auch der Stand der Technik.

Bevorzugte Diphenolbausteine der Formel (2) sind z.B. 1,1-Bis-(4-hydroxyphenyl)-cyclohexan und 1,1-Bis-(4-hydroxyphenyl)-3,3,5-trimethylcyclohexan, bevorzugt 1,1-Bis-(4-hydroxyphenyl)-3,3,5-trimethylcyclohexan.

Dabei sind Copolycarbonate bevorzugt, die 15 Gew.-% bis 95 Gew.-% insbesondere bevorzugt 25 Gew.-% bis 90 Gew.-% Diphenolbaustein der Formel (2) bezogen auf die Summe der Bisphenolkomponenten enthalten.

Ausser den Diphenolen der Formel (2) sind für die Herstellung der Copolycarbonate geeignete Dihydroxyarylverbindungen solche der Formel (3)

HO-Z -OH (3)

in welcher
Z ein aromatischer Rest mit 6 bis 30 C-Atomen ist, der einen oder mehrere aromatische Kerne enthalten kann, substituiert sein kann und aliphatische oder cycloaliphatische Reste bzw. Alkylaryle oder Heteroatome als Brückenglieder enthalten kann.
Bevorzugt steht Z in Formel (3) für einen Rest der Formel (3 a) 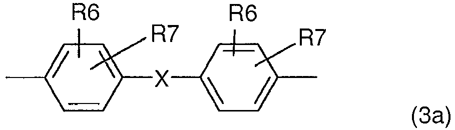 in der
R6 und R7 unabhängig voneinander für H, C₁-C₁₈-Alkyl-, C₁-C₁₈-Alkoxy, Halogen wie Cl oder Br oder für jeweils gegebenenfalls substituiertes Aryl- oder Aralkyl, bevorzugt für H oder C₁-C₁₂-Alkyl, besonders bevorzugt für H oder C₁-C₈-Alkyl und ganz besonders bevorzugt für H oder Methyl stehen, und
X für -CO-, -O-, -S-, C1- bis C6-Alkylen, C₂- bis C₅-Alkyliden oder für C₆- bis C₁₂-Arylen, welches gegebenenfalls mit weiteren Heteroatome enthaltenden aromatischen Ringen kondensiert sein kann, steht.

Bevorzugt steht X für, C₁ bis Cs-Alkylen, C₂ bis C₅-Alkyliden, -O-, -SO-, -CO-, -S-, -SO2-, Isopropyliden oder Sauerstoff, insbesondere für Isopropyliden.

Für die Herstellung der erfindungsgemäss zu verwendenden Copolycarbonate geeignete Diphenole der Formel (3) sind beispielsweise Hydrochinon, Resorcin, Bis-(hydroxyphenyl)-alkane, Bis-(hydroxyphenyl)-sulfide, Bis-(hydroxyphenyl)-ether, Bis-(hydroxyphenyl)-ketone, Bis-(hydroxyphenyl)-sulfone, Bis-(hydroxyphenyl)-sulfoxide, [alpha],[alpha]'-Bis-(hydroxyphenyl)-diisopropylbenzole, sowie deren alkylierte, kernalkylierte und kernhalogenierte Verbindungen.

Ferner bevorzugte Diphenole der Formel (3) sind 4,4'-Dihydroxydiphenyl, 2,2-Bis-(4-hydroxyphenyl)-1-phenyl-propan, 1,1-Bis-(4-hydroxyphenyl)-phenyl-ethan, 2,2-Bis-(4-hydroxyphenyl)propan, 2,2-Bis-(3-methyl, 4-hydroxyphenyl)-propan, 2,4-Bis-(4-hydroxyphenyl)-2-methylbutan, 1,3-Bis-[2-(4-hydroxyphenyl)-2-propyl]benzol (Bisphenol M), 2,2-Bis-(3-methyl-4-hydroxyphenyl)-propan, Bis-(3,5-dimethyl-4-hydroxyphenyl)-methan, 2,2-Bis-(3,5-dimethyl-4-hydroxyphenyl)-propan, Bis-(3,5-dimethyl-4-hydroxyphenyl)-sulfon, 2,4-Bis-(3,5-dimethyl-4-hydroxyphenyl)-2-methylbutan, 1,3-Bis-[2-(3,5-dimethyl-4-hydroxyphenyl)-2-propyl]-benzol.

Besonders bevorzugte Diphenole der Formel (3) sind 2,2-Bis-(4-hydroxyphenyl)-propan (BPA), und 2,2-Bis-(3-methyl, 4-hydroxyphenyl)-propan.

Insbesondere bevorzugt sind Copolycarbonate aus Bisphenol A und Bisphenol TMC.

Diese und weitere geeignete Diphenole sind kommerziell erhältlich und z. B. in "H. Schnell, Chemistry and Physics of Polycarbonates, Interscience Publishers, New York 1964, S. 28 ff; S. 102 ff" , und in "D. G. Legrand, J. T. Bendler, Handbook of Polycarbonate Science and Technology, Marcel Dekker New York 2000, S. 72 ff." beschrieben.

Besonders bevorzugt sind statistische Copolycarbonate.

Die thermoplastischen Copolycarbonate haben Molekulargewichte Mw (Gewichtsmittel Mw, ermittelt durch Gelpermeationschromatographie GPC Messung) von 12 000 bis 120 000, vorzugsweise von 15 000 bis 80 000, insbesondere von 18 000 bis 60 000, ganz besonders bevorzugt von 18 000 bis 40 000 g/mol. Molekulargewichte lassen sich auch durch die Zahlenmittel Mn angeben, welche ebenfalls nach vorheriger Eichung auf Polycarbonat mittels GPC bestimmt werden.

Die Basisschicht enthält dabei zu 5 Gew.-% - 50 Gew.-% bevorzugt 10 Gew.-% - 40 Gew.-% insbesondere bevorzugt zu 15 Gew.-% -35 Gew.-%, bezogen auf die die Summe eingesetzter Thermoplaste, anorganische Füllstoffe mit sphärischer oder Plättchengeometrie, wobei der Füllstoff ausgewählt ist aus der Gruppe bestehend aus Nitriden, Oxiden, Mischoxiden, Carbiden, gepulvertem Quarz, SiO₂-Partikeln, amorphem SiO₂, gemahlenem Sand, Glaspartikeln, Glasvollkugeln und synthetischem Graphit. Bevorzugt sind die Füllstoffe mit sphärischer oder Plättchengeometrie in feinteiliger und/oder poröser Form mit großer äußerer und/oder innerer Oberfläche. Plättchenförmig meint in diesem Zusammenhang flache Körper mit einer großen unterschiedlichen Ausdehnung in den drei Dimensionen - so hat z.B. die Dicke einen deutlich kleineren Werte als die Ausdehnung des Partikels in der Länge bzw.

Breite. Der Quotient aus Länge bzw. Durchmesser wird auch als Aspektverhältnis bezeichnet. Für die vorliegende Erfindung sind dabei Teilchen mit einem Aspektverhältnis von 1000:1 bis 10:1 geeignet. Dabei handelt es sich um thermisch inerte anorganische Materialien insbesondere basierend auf Nitriden wie Bornitrid, um Oxide oder Mischoxide, um Carbide wie Wolframcarbid oder Borcarbid, gepulvertem Quarz wie Quarzmehl, SiO₂-Partikel wie Nanopartikeln, amorphes SiO₂, gemahlener Sand, Glaspartikel wie Glaspulver, insbesondere Glaskugeln, Graphit, insbesondere hochreiner synthetischer Graphit. Insbesondere bevorzugt sind dabei Quarz und synthetischer Graphit.

Der in der vorliegenden Erfindung verwendbare Graphit kann elektrisch leitfähig sein. Der Graphit ist vorzugsweise ausgewählt aus einem synthetischen oder natürlichen Graphit. Insbesondere bevorzugt ist synthetischer Graphit. Der Graphit kann, plättchenartige oder sphärische Teilchenform oder ein Gemisch dieser Teilchenformen aufweisen. Bevorzugt ist der Graphit plättchenförmig. Plättchenförmig meint in diesem Zusammenhang flache Körper mit einer großen unterschiedlichen Ausdehnung in den drei Dimensionen - so hat z.B. die Dicke einen deutlich kleineren Wert als die Ausdehnung des Partikels in der Länge bzw. Breite. Die Plättchen können aus einer Graphitlage oder aus mehreren Lagen bestehen, welche dicht gepackt vorliegen. Die kleinste Dimension (Dicke) ist dabei geringer als 1 µm bevorzugt geringer als 500 nm und am meisten bevorzugt geringer als 200 nm und wenigstens 0,4 nm bevorzugt 1 nm, wobei das Aspektverhältnis im Bereich von 1000:1 bis 10:1 liegt. Für den erfindungsgemäßen Nutzen ist es nicht nötig dass alle plättchenförmige Partikel eine ebenmäßig flache Form aufweisen. Durch die geringe Dicke der Partikel können diese eine kurvenförmige oder gebogene Form oder andere Defomitäten aufweisen. Die Dicke der Partikel kann mit Standardmethoden wie z.B. Transmissionselektronemikroskopie bestimmt werden.

Der Graphit kann einzelne Graphitteilchen oder Aggregate oder Agglomerationen von Graphitteilchen enthalten. Bevorzugt weisen die Teilchen, Aggregate oder Agglomerationen eine mittlere Teilchengröße (d90%) von 1-160 µm auf, stärker bevorzugt 5-100 und weiter bevorzugt 10 - 60 µm auf. In einer anderen Ausführungsform weist der Graphit einen Veraschungsrückstand von kleiner als 0,5% auf, bevorzugt kleiner als 0,1 gew.-%, gemessen nach ASTM D 1506. In einer weiteren Ausführungsform weist der Graphit eine Feuchte von kleiner als 0,5% auf, gemessen nach ASTM D 1509-95. Bevorzugt weist der Graphit eine BET Oberfläche von mindestens 5 m²/g, insbesondere bevorzugt mindestens 8 m²/g auf. Die BET-Oberfläche wird bestimmt nach ASTM D3037.

Der Graphit wird mittels eines allgemein bekannten Graphitierungsprozesses hergestellt. Dabei sind die Ausgangssubstanzen zum Beispiel Braunkohle, Erdöle und Peche, aber auch Kunststoffe. Bei der Graphitierung erfolgt durch Erhitzen unter Luftabschluss auf etwa 3.000°C noch eine Umwandlung vom amorphen Kohlenstoff zum polykristallinen Graphit.

Der Graphit wird als Feststoff eingesetzt. Handelsüblicher Graphit für Druckanwendungen kann verwendet werden, wie er beispielsweise bei der Firma TIMCAL AG, CH-6743 Bodio, Schweiz, vorzugsweise unter der Bezeichnung TIMREX KS44 oder TIMREX KS150, KS 75, KS 5-75TT, KS 5-44, KS 6 insbesondere bevorzugt KS 44, erhältlich ist.

Werden Glaskugeln eingesetzt werden diese bevorzugt in Form von Glaskugeln bzw. Glaskügelchen (auch runde Glassphären oder Mikrosphären genannt) mit einem Durchmesser von 4 µm bis 120 µm eingesetzt. Die zum Einsatz gelangenden Glaskugeln sind handelsüblich erhältlich - wie z.B. Produkte der Fa. Potters Europe) und werden beispielsweise als Spheriglas, Typ 5000, mit einem Durchmesser von 4 µm bis 25 µm Spheriglas, Typ 3000, mit einem Durchmesser von 12 µm bis 48 µm und Spheriglas, Typ 2429, mit einem Durchmesser von 53 µm bis 106 µm gehandelt. Je kleiner die Glaskugeln sind, umso größer ist ihre Anzahl und Oberfläche pro Gewichtseinheit. Die Korngestalt ist dabei näherungsweise sphärisch. Bevorzugt handelt es sich um Vollglaskugeln, keine Hohlglaskugeln.

Es eignen sich jedoch auch andere ähnliche Materialien wie z.B. Porzellankugeln. Dabei ist zu beachten, dass sich für den erfindungsgemäßen Zweck insbesondere bevorzugt Glaskugeln aus Borosilikatglas (E-Glas) zum Einsatz kommen. A Glas (Kalk-Natron Glas) ist für die vorliegende Erfindung wegen der hohen thermischen Anforderungen ungeeignet.

In einer weiteren Ausführungsform kommen bevorzugt anorganische Füllstoffen, die zu über 97 Gew.% auf der Basis von Quarz (SiO₂) aufgebaut sind, zum Einsatz. Die Korngestalt ist dabei näherungsweise sphärisch.

In bevorzugter Ausführungsform handelt es sich dabei um feinteilige Quarzmehle, die durch eisenfreie Mahlung mit nachfolgender Windsichtung aus aufbereitetem Quarzsand hergestellt wurden.

Insbesondere bevorzugt sind Quarzpartikel mit einem Partikelgröße von D50% 0,1µm - 100µm bevorzugt 1µm - 50µm und ganz besonders bevorzugt von 1µm bis 5µm und einem D98% Wert von 1µm - 100µm bevorzugt 5µm - 50µm. Bevorzugt weisen die Quarzpartikel eine spezifische BET-Oberfläche, bestimmt durch Stickstoffadsorption gemäß ISO 9277 von 0,5 - 10 m²/g auf. Die Partikel können ggf. beschichtet sein wobei bevorzugt Epoxysilan-, Methylsiloxan-, und Methacrylsilan-Schlichten zum Einsatz kommen.

Geegnete handelsübliche Produkte sind z.B Sikron SF 500 und Sikron SF 800 der Firma Quarzwerke GmbH (50226 Frechen, Deutschland).

Es können auch Mischungen aus verschiedenen Füllstoffen verwendet werden.

Völlig überraschend war die Tatsache, dass sich vergleichbare sphärische oder plättchenförmige Füllstoffe auf Basis anderer Zusammensetzungen als erfindungsgemäß genannt, nicht für das beschriebene Substratmaterial eignen. So konnte gezeigt werden, dass Schichtsilikate wie Tone, Talke oder Kaolin ungeeignet im Sinne der Erfindung sind. Auch Glasfasern, welche für die Verringerung des Wärmeausdehnungskoeffizienten in Frage kommen, sind ungeeignet. Damit ist nur ein sehr kleiner Teil der theoretisch für die Verringerung des thermischen Ausdehnungskoeffizeinenten möglichen Einsatzstoffe im Sinne der Erfindung geeignet. Welche Füllstoffe dies sind, war zuvor unbekannt und konnte auch vom Fachmann aus dem Stand der Technik nicht abgeleitet werden.

Bevorzugt wird diese Schicht in einem Spritzgussverfahren oder Thermo-Umformungsverfahren mit Werkzeugtemperaturen von ähnlich oder oberhalb der Vicat-Erweichungstemperatur des eingesetzten Substratmaterials hergestellt.

In einer weiteren Ausführungsform wird dem Copolycarbonat der Substratschicht a) weitere Polymere basierend auf Polsulfon., Polyethersulfon oder Polyetherimid beigemischt. Dabei beträgt der Polycarbonatgehalt in der Mischung bezogen auf die Summe eingesetzter Thermoplaste bevorzugt mehr als 50 Gew.-%, besonders bevorzugt mehr als 60 Gew.-% und insbesondere bevorzugt mehr als 70 Gew.-%. Bevorzugt sind z.B. sogenannten Polyethersulfone (CAS: 25608-63-3) welche z.B. unter dem Handelsnamen Ultrason® E 2010 bei der BASF SE (67056 Ludwigshafen, Deutschland) erhältlich sind. Weiterhin bevorzugt sind sogenannte Polyphenylsulfone (CAS 25608-64-4) - diese sind unter dem Handelsnamen Radel® R (z.B. Radel® R 5900) bei Solvay Advanced Polymers oder Ultrason® P bei BASF SE (67056 Ludwigshafen, Deutschland) erhältlich. Polyetherimide sind z.B. unter Handelsnamen Ultem® (CAS 61128-46-9) (Sabic Innovative Plastics) bekannt.

Auch Mischungen der oben genannten Polymere sind möglich.

In einer bevorzugten Ausführungsform trägt die Schicht b) eine Schutzschicht c) bestehend aus plasmapolymerisierten Siloxanen der Dicke 5 nm - 200 nm, bevorzugt 15 nm - 150 nm ganz besonders bevorzugt 20 nm - 100 nm.

In einer weiteren speziellen Ausführungsform kann weiterhin eine Schicht d) enthalten sein, die eine Kondensatbildung auf der Oberfläche verhindert.

Die erfindungsgemässen Mehrschichtkörper weisen signifikant verbesserte thermische Eigenschaften (Vicat-Erweichungstemperatur) in Verbindung mit einer guten Metallisierbarkeit auf. Die Oberflächenqualität bei auch bei hoher Temperaturbelastung erhalten. Dabei bleiben die mechanischen, thermischen und rheologischen Eigenschaften gegenüber den Standard-Copolycarbonaten (wie z.B. Apec) unverändert. Ferner weisen sie die geforderten niedrigen linearen Wärmeausdehnungskoeffizienten auf. Zudem weist das Substratmaterial eine hohe Schmelzestabilität auf.

Die Polymerzusammensetzung des Substratmaterials kann niedermolekulare Additive enthalten. Allerdings ist es bevorzugt mit möglichst geringen Mengen an Additiven zu arbeiten. In einer besonderen Ausführungsform enthält die Polymerzusammensetzung keine niedermolekularen Additive - Füllstoffe sind hierbei ausdrücklich ausgenommen.

Als Thermostabilisator eignen sich bevorzugt Tris-(2,4-di-tert-butylphenyl)phosphit (Irgafos 168), Tetrakis(2,4-di-tert.-butylphenyl)[1,1 biphenyl]-4,4'-diylbisphosphonit, Trisoctylphosphat, Octadecyl-3-(3,5-di-tert butyl-4-hydroxyphenyl)propionat (Irganox 1076), Bis(2,4-dicumylphenyl)pentaerythritoldiphosphit (Doverphos S-9228), Bis(2,6-di-tert.butyl-4-methylphenyl)pentaerythritoldiphosphit (ADK STAB PEP-36). Sie werden allein oder im Gemisch (z. B. Irganox B900 oder Doverphos S-92228 mit Irganox B900 bzw. Irganox 1076) eingesetzt. In einer besonders bevorzugten Ausführungsform wird kein Thermostabilisator eingesetzt.

Als Entformungsmitttel eignen sich bevorzugt Pentaerythrittetrastearat, Glycerinmonostearat, Stearylstearat oder Propoandiolmono- bzw. distearat. Sie werden allein oder im Gemisch eingesetzt. In einer besonderen Ausführungsform wird kein Entformungsmittel eingesetzt. Als UV-Stabilisatoren eignen sich bevorzugt 2-(2'-Hydroxyphenyl)benzotriazole, 2-Hydroxybenzophenone, Ester von substituierten und unsubstituierten Benzoesäuren, Acrylate, sterisch gehinderte Amine, Oxamide, 2-(2-Hydroxyphenyl)-1,3,5-triazine, besonders bevorzugt sind substituierte Benztriazole wie beispielsweise Tinuvin 360, Tinuvin 350, Tinuvin 234, Tinuvin 329 oder UV CGX 006 (Ciba). In einer besonderen Ausführungsform wird kein UV-Absorber eingesetzt.

Des Weiteren können Farbmittel, wie organische Farbstoffe oder Pigmente oder anorganische Pigmente, IR-Absorber, einzeln, im Gemisch oder auch in Kombination mit Prozesshilfsmitteln eingesetzt werden. Dabei ist die erfindungsgemäße Zusammensetzung bevorzugt frei von Titandioxid.

Die Zusammensetzung kann weitere handelsübliche Polymeradditive wie Flammschutzmittel, Flammschutzsynergisten, Antidrippingmittel (beispielsweise Verbindungen der Substanzklassen der fluorierten Polyolefine und der Silikone), Nukleiermittel, Antistatika wie Polyalkylenether, Alkylsulfonate oder Polyamid-haltige Polymere) in solchen Mengen enthalten, die die mechanischen Eigenschaften der Zusammensetzung nicht insoweit schädigen, dass das Zieleigenschaftsprofil nicht mehr erfüllt wird.

Geeignete Additive sind beispielsweise, jedoch nicht limitierend, beschrieben in "Additives for Plastics Handbook, John Murphy, Elsevier, Oxford 1999", im "Plastics Additives Handbook, Hans Zweifel, Hanser, München 2001" oder in WO 99/55772 , S. 15-25.

Die Herstellung der für das Substratmaterial des erfindungsgemäßen Mehrschichtkörpers benötigten thermoplastischen Formmassen erfolgt, indem man die jeweiligen Bestandteile in bekannter Weise vermischt und bei Temperaturen von 200 °C bis 380 °C, bevorzugt bei 240 bis 350 °C, in üblichen Aggregaten wie Innenknetern, Extrudern und Doppelwellenschnecken schmelzecompoundiert und schmelzextrudiert (Mischung in der Schmelze).

Die Polymerzusammensetzungen werden insbesondere zur Herstellung von Bauteilen verwendet, bei denen optische, thermische und mechanische Eigenschaften genutzt werden, wie beispielsweise bei Gehäusen, Gegenständen im E/E-Bereich, Platten, Lampenhalterungen, -abdeckungen, im Automobilbereich wie Lampenfassungen und -abdeckungen, Lichtsammelsystemen und -reflektoren - insbesondere im Bereich der Photovoltaik, Kollimatoren, Leuchtdioden, bedampfte Displays und Scheiben; Linsenhalterungen, Lichtleiterlemente, bei LED-Anwendungen (Sockel, Reflektoren, heat sinks); Automobilteile wie Scheinwerfer, Bezels, Blinker, Reflektoren und andere Anwendungen.

Die Extrudate und Formkörper bzw. Formteile aus den erfindungsgemässen Polymeren sind ebenfalls Gegenstand der vorliegenden Anmeldung.

Die Copolycarbonate, zur Herstellung der Schicht a) werden nach einem kontinuierlichen Phasengrenzflächenverfahren hergestellt. Die Herstellung der erfindungsgemäss zu verwendenden Copolycarbonate erfolgt prinzipiell in bekannter Weise aus Diphenolen, Kohlensäurederivaten und gegebenenfalls Verzweigern.

Allgemein ist das Verfahren zur Polycarbonatsynthese bekannt und in zahlreichen Publikationen beschrieben. EP 517 044 A1, WO 2006/072344 A1, EP 1 609 818 A1 und WO 2006/072344 A1 und dort zitierte Dokumente beschreiben beispielsweise das Phasengrenzflächen und das Schmelzeverfahren zur Herstellung von Polycarbonat.

Die verwendeten Diphenole, wie auch alle anderen der Synthese zugesetzten Chemikalien und Hilfsstoffe können mit den aus ihrer eigenen Synthese, Handhabung und Lagerung stammenden Verunreinigungen kontaminiert sein. Es ist jedoch wünschenswert, mit möglichst reinen Rohstoffen zu arbeiten.

Die Durchführung der Copolycarbonatsynthese erfolgt kontinuierlich. Die Reaktion kann in daher in Umpumpreaktoren, Rohrreaktoren, oder Rührkesselkaskaden oder deren Kombinationen erfolgen, wobei durch Verwendung der bereits erwähnten Mischorgane sicherzustellen ist, dass wässrige und organische Phase sich möglichst erst dann entmischen, wenn das Synthesegemisch ausreagiert hat, d. h. kein verseifbares Chlor von Phosgen oder Chlorkohlensäureestern mehr enthält.

Die Menge an einzusetzenden Kettenabrecher beträgt 0,5 Mol-% bis 10 Mol-%, bevorzugt 1 Mol-% bis 8 Mol-%, besonders bevorzugt 2 Mol-% bis 6 Mol-% bezogen auf Mole an jeweils eingesetzten Diphenolen. Die Zugabe der Kettenabbrecher kann vor, während oder nach der Phosgenierung erfolgen, bevorzugt als Lösung in einem Lösungsmittelgemisch aus Methylenchlorid und Chlorbenzol (8-15 Gew.%-ig).

Die Herstellung des Formteils aus dem Substratmaterial zur Herstellung des erfindungsgemäßen Mehrschichtkörpers erfolgt bevorzugt im Spritzgussverfahren wobei die Werkzeugtemperatur in einer ähnlichen Größenordnung wie die Vicat-Erweichungstemperatur des verwendeten Substratmaterials eingestellt ist - siehe unten. Der Prozess der sogenannten dynamischen Werkzeugtemperierung ist dadurch gekennzeichnet, dass die Werkzeugwand vor dem Einspritzen der Schmelze zügig aufgeheizt wird. Durch die erhöhte Werkzeugtemperatur, die im Idealfall nahe bei der Vicattemperatur oder größer als die Vicattemperatur des verwendeten Substratmaterials liegt wird das frühzeitige Erstarren der Schmelze verhindert, sodass unter anderem eine höhere Abformgenauigkeit der Werkzeugoberfläche möglich ist und sich die Qualität der Bauteiloberfläche verbessert. Damit wird überraschenderweise auch erreicht, dass sich die im Substratmaterial enthaltenen Füllkörper derart orientieren, dass ein hoher Oberflächenglanz erreicht wird. Die Temperatur der Werkzeugwand sollte im Bereich der Vicattemperatur +/- 20°C (bedeutet mit einer Abweichung von 20°C nach oben oder nach untern), bevorzugt im Bereich +/- 10°C, besonders bevorzugt im Bereich + 3 °C bis +7 °C oberhalb der Vicattemperatur liegen. Des Weiteren ist die dynamische Werkzeugtemperierung dadurch gekennzeichnet, dass die Temperatur der Werkzeugwand nach dem Einspritzvorgang möglichst schnell wieder auf die ursprüngliche Temperatur heruntergekühlt wird und das Bauteil wie üblich bis zur Entformungstemperatur im Werkzeug abkühlt. Für die Fertigung der genannten Bauteile eignet sich besonders gut die dynamische Werkzeugtemperierung mithilfe einer Induktionsheizung.

Die Metallisierung der Schicht a) erfolgt bevorzugt in einem DC Sputterverfahren.

Überraschenderweise wurde gefunden, dass ein bestimmtes Verfahren mit bestimmten Verfahrensparametern zu stabilen Metallschichten führt. So konnte gezeigt werden, dass die Kombination mit bestimmten Drücken und bestimmten Leistungen während der Vorbehandlung zu besseren Ergebnissen führen. Niedrigere Energien führen überraschenderweise dazu, dass die anschließende Metallschicht bei Wärmebehandlung Fehler ausbildet. Dies war unerwartet. Im Vergleich dazu kann die generelle d Metallhaftung auch mit niedrigen Vorbehandlungsenergien erreicht werden. Die Metallhaftung kann z.B. mit einem Peeltest (Klebebandabzugstest) getestet werden. Die Blisterbildung (Ausbildung blasenartiger Fehlstellen) nach Wärmebehandlung kann jedoch nur durch das erfindungsgemäße Verfahren verhindert werden. Die Herstellung des erfindungsgemäßen Mehrschichtkörpers erfolgt dabei bevorzugt in folgenden Schritten:
A) Herstellung der Basisschicht a) nach oben beschriebenen Verfahren.
B) Vorbehandlung des erhaltenen Formteils (Basisschicht) enthaltend ein Substratmaterial aus einem Copolycarbonat bevorzugt einem Copolycarbonat mit einem Gewichtsanteil an 1,1-Bis-(4-hydroxyphenyl)-3,3,5-trimethylcyclohexan von 15 Gew.-% bis 95 Gew.-% insbesondere bevorzugt 25 Gew.-% bis 90 Gew.-% bezogen auf die Summe der Bisphenolkomponentenin einer Diodenanordnung mit Mittelfrequenzanregung mit einem Luft- oder Argon-basierten Plasma, bevorzugt Argon, bei einer Frequenz von 0 Hz - 10 Mhz bevorzugt von 0 Hz - 1 Mhz ganz besonders bevorzugt 0 Hz - 100 kHz einer Leistung von 0,4 W/cm² bis 8,4 W/cm² bevorzugt 0.5 W/cm² bis 5,0 W/cm² insbesondere bevorzugt von 0,8 W/cm² bis 3,3 W/cm² sowie einem Prozessgasdruck von 0,04 bis 0,2 mbar bevorzugt von 0,05 bis 0,16 mbar. Als Prozessgase werden Luft, N₂, N₂O, Ar, He, O₂, bevorzugt Luft oder Argon besonders bevorzugt Argon eingesetzt. Die Dauer der Behandlung beträgt 10 Sekunden bis 1000 Sekunden, bevorzugt 30 Sekunden bis 500 Sekunden und insbesondere bevorzugt 30 Sekunden - 180 Sekunden.
C) Metallisierung des Formteils in einem Sputterprozess in einem DC-Magnetron in einem Argon-Plasma bei einem Druck von 5x10⁻³ mbar aus Aluminium, Silber, Chrom, Titan, Palladium, bevorzugt aus Silber oder Aluminium, insbesondere bevorzugt Aluminium bei einer Prozesszeit von 10 Sekunden bis 1000 Sekunden.
   Die Dicke der Metallschicht beträgt bevorzugt 10 nm - 1000 nm, bevorzugt 50 nm - 800 nm insbesondere bevorzugt 60 nm - 500 nm und ganz besonders bevorzugt 60 nm - 300 nm.
D) Auftrag einer Schutzschicht (nachfolgend auch Top Coat genannt) mit der unter b) beschriebenen technischen Einrichtung. Dies geschieht bei einem Druck von 0,01 bis 0,30 mbar mit bevorzugt HMDSO (Hexamethyldisiloxan; CAS 107-46-0) als Beschichtungsmaterial bei einer Prozesszeit von 10 Sekunden - 1000 Sekunden bevorzugt 20 Sekunden bis 500 Sekunden. Die Schichtdicke des Top Coats beträgt 10 nm - 200 nm bevorzugt 20 nm - 100 nm. Die angelegte Leistung beträgt 100W - 5000W.

### Beispiele

Im Folgenden wird die Erfindung anhand von Ausführungsbeispielen näher beschrieben, wobei die hier beschriebenen Bestimmungsmethoden für alle korrespondierenden Größen in der vorliegenden Erfindung zur Anwendung kommen, sofern nichts Gegenteiliges beschrieben worden ist.

Die Bestimmung des Schmelzvolumenrate (MVR) erfolgt nach ISO 1133 unter den unten angegebenen Bedingungen.

### Materialien:

### Substratmaterial 1 (für Vergleichsbeispiel)

Copolycarbonat enthaltend 70 Gew.-% 1,1-Bis-(4-hydroxyphenyl)-3,3,5-trimethylcyclohexan und 30 Gew.-% Bisphenol A mit Phenol als Kettenabbrecher und einem MVR von 8 cm³/(10 min) (330 °C; 2,16 kg) gemäß ISO 1133. Das Material weist eine Vicat-Erweichungstemperatur von 208 °C auf (ISO 306; 50 N; 120 K/h).

### Substratmaterial 2 (für erfindungsgemäßen Mehrschichtkörper)

Copolycarbonat enthaltend 70 Gew.-% 1,1-Bis-(4-hydroxyphenyl)-3,3,5-trimethylcyclohexan und 30 Gew.-% Bisphenol A mit Phenol als Kettenabbrecher und einem MVR von 8 cm³/(10 min) (330 °C; 2,16 kg) gemäß ISO 1133 wird mit 20 Gew.-% Graphit (Timrex KS 44 der Firma Timcal AG, CH-6743 Bodio, Schweiz) unter unten beschriebenen Bedingungen compoundiert. Das resultierende Material hat eine Vicat-Erweichungstemperatur von 203 °C (ISO 306; 50 N; 120 K/h).

### Substratmaterial 3 (für Vergleichsbeispiel)

Copolycarbonat enthaltend 70 Gew.-% 1,1-Bis-(4-hydroxyphenyl)-3,3,5-trimethylcyclohexan und 30 Gew.-% Bisphenol A mit Phenol als Kettenabbrecher und einem MVR von 8 cm³/(10 mi.n) (330 °C; 2,16 kg) gemäß ISO 1133 wird mit 20 Gew.-% Talkum (Finntalc M05SL-AW der Firma Mondo Minerals B.V. ; NL-1041 Amsterdam) unter unten beschriebenen Bedingungen compoundiert. Das resultierende Material weist eine Vicat-Erweichungstemperatur von 198 °C auf (ISO 306; 50 N; 120 K/h).

### Compoundierung

Die Compoundierung der Materialien erfolgte auf einem Zweiwellenextruder der Firma KraussMaffei Berstorff, TYP ZE25, bei einer Gehäusetemperatur von 320 °C bzw. einer Massetemperatur von ca. 340°C und einer Drehzahl von 100 Upm mit den in den Beispielen angegebenen Mengen an Komponenten.

### Herstellung der Prüfkörper:

Für die Herstellung von Formteilen (Rechteckmusterplatten mit Seitenanguss in optischer Qualität in 2 mm Dicke), welche in den Beispielen 1 und 2 zur Metallisierung verwendet wurden, wurde mit einer dynamischen Werkzeugtemperierung gearbeitet. Der Spritzguss erfolgte auf einer Battenfeld HM 210 bei einer Massetemperatur von ca. 350 °C und einer Werkzeugtemperatur von ca. 210 °C. Das Granulat wurde vor Verarbeitung für 5 Stunden im Vakuumtrockenschrank bei 120 °C getrocknet. Als Substratmaterial wurde Substratmaterial 2 verwendet.

### Messung der Wärmeformbeständigkeit über die Vicat-Erweichungstemperatur:

Die Vicat-Erweichungstemperatur nach DIN EN ISO 306 wird mit einer Nadel (mit kreisrunder Fläche von 1 mm²) gemessen. Diese ist mit einer Prüfkraft von 50 N (Prüfkraft B) belastet. Der oben genannte Probekörper wird einer definierten Heizrate von 120 K/h ausgesetzt. Die Vicattemperatur ist erreicht, wenn der Eindringkörper eine Eindringtiefe von 1 mm erreicht. Sie wird nach DIN ISO 306 gemessen.

### Glanzmessung (Gloss):

Die Glanzmessung erfolgte an einem BYK Haze Gloss Gerät nach ASTM D 523 an metallisierten Musterplatten unter verschiedenen Einstrahlwinkeln.

### Messung der Wärmeausdehnung:

Die Längenausdehnungskoeffizienten werden mittels eines Mettler TMA 841-Messgerätes unter Stickstoff ermittelt (Messbereich 23 - 55 °C). Als Norm kommt die ASTM E 831 zur Anwendung.
Die für die Messung benötigten Probekörper (Rechteckmusterplatte) werden nach Trockung des Granulates bei 130 °C über Nacht durch Spritzguss hergestellt. Gemessen wird jeweils quer und längs des Probekörpers.

### Schmelzestabilität

Zur Evaluierung der Schmelzestabilität wird die Schmelzvolumenrate (MVR) nach verschiedenen Vorwärmzeiten gemessen.

### Metallisierungsprozess:

Alle Platten wurden vor der Beschichtung für 21 Tage bei 50 % Luftfeuchtigkeit und 23 °C gelagert.

Die Beschichtungsanlage bestand aus einer Vakuumkammer bei der die Proben auf einem rotierenden Probenhalter positioniert wurden. Der Probenhalter rotierte mit ca. 20 U/min. Die Prüfkörper wurden, bevor sie in die Vakuumkammer eingebracht wurden, mit ionisierter Luft abgeblasen, um sie von Staub zu befreien. Danach wurde die Vakuumkammer mit den Prüfkörper auf einen Druck p ≤ 1 · 10⁻⁵ mbar evakuiert. Anschließend wurde Argon Gas bis zu einem bestimmten Druck, welcher in den Ausführungsbeispielen beschrieben ist (Prozessdruck 1) eingelassen und bei einer bestimmten Leistung, welche in den Ausführungsbeispielen beschrieben ist (Prozessleistung 1) für 2 min ein Plasma gezündet und die Proben diesem Plasma ausgesetzt (Plasma Vorbehandlung). Als Plasmaquelle wurde eine Diodenanordung bestehend aus 2 parallelen Metallelektroden verwendet, die mit einer Wechselfrequenz von 40 kHz und einer Spannung größer 1000 V betrieben wurde. Danach wurden die Proben metallisiert. Dafür wurde Ar-Gas mit einem Druck von 5· 10⁻³ mbar eingelassen. Mittels DC-Magnetron wurde eine Aluminium-Schicht von ca. 100 nm Dicke mit einer Leistungsdichte von 6,4 W/cm² auf die Proben aufgebracht. Die Sputterzeit betrug 2,5 Minuten. Danach wurde mittels Plasmapolymerisation eine Korrosionsschutzschicht aus HMDSO (Hexamethyldisiloxan; CAS 107-46-0) aufgebracht. Dazu wurde HMDSO verdampft und der Dampf in die Vakuumkammer eingelassen bis sich ein Druck von ca. 0,04 mbar ergab. Danach wurde ein Plasma mit der oben beschriebenen Diodenanordnung bei 1500W gezündet während 1 Minute die Korrosionschutzschicht aufgebracht.

### Test der Oberflächenqualität nach Wärmelagerung:

Der Test wird direkt nach der Metallisierung durchgeführt. Damit ist gemeint, dass die Platten nach Metallisierung innerhalb einer Stunde diesem Test unterworfen werden.

Die metallisierten Platten werden dabei in einer Klimakammer für 2 Stunden bei 45 °C und 100 % relativer Feuchte gelagert. Direkt nach der Klimalagerung werden die Platten für eine Stunde bei 170 bzw. 180 °C in einem Ofen gelagert.

Danach wird die Metalloberfläche abgemustert.

### Visuelle Abmusterung:

Die Oberfläche wird auf blasenförmige Aufwerfungen, Eintrübung der Metallschicht sowie auf Irisierung untersucht. Platten, die weder Irisierung noch Trübung, noch Blasen aufweisen, werden als "fehlerfrei" gekennzeichnet.

### Beispiel 1 (Erfindungsgemäß)

Es werden Spritzguss-Rechteckplatten von Komponente Substratmaterial 2 wie oben beschrieben angefertigt.

Danach werden die Probekörper wie oben beschrieben metallisiert. Der Prozessdruck 1 beträgt dabei 0,09 mbar und die Prozessleistung 1 beträgt dabei 1,67 W/cm². Alle anderen Parameter zur Herstellung der Metallschicht bzw. Erzeugung des Topcoats werden wie oben beschrieben eingestellt.

Das Ergebnis der Prüfung (Wärmelagerung) ist in Tabelle 1 dargestellt.

### Beispiel 2 (Vergleichsbeispiel)

Es werden Spritzguss-Rechteckplatten von Komponente Substratmaterial 2 wie oben beschrieben angefertigt.

Danach werden die Probekörper wie oben beschrieben metallisiert. Der Prozessdruck 1 beträgt dabei 0,09 mbar und die Prozessleistung 1 beträgt dabei 0,17 W/cm². Alle anderen Parameter zur Herstellung der Metallschicht bzw. Erzeugung des Topcoats werden wie oben beschrieben eingestellt.

Das Ergebnis der Prüfung (Wärmelagerung) ist in Tabelle 1 dargestellt.

**Tabelle 1**

| Bsp. | Substrat | Vorbehandlung Sputterprozess | Temperatur Wärmelagerg | Visuelle Abmusterung |
|---|---|---|---|---|
| 1 | Substratmaterial 2 | P-leistung 1: 1,67 W/cm² | 170 °C | fehlerfrei |
| Erfindungsgemäß | | P-druck 1: 0,09 mbar | | |
| 1 | Substratmaterial 2 | P-leistung 1: 1,67 W/cm² | 180 °C | fehlerfrei |
| Erfindungsgemäß | | P-druck 1: 0,09 mbar | | |
| 2 | Substratmaterial 2 | P-leistung 1: 0,17 W/cm² | 170 °C | Blasen |
| Vergleich | | P-druck 1: 0,09 mbar | | |
| 2 | Substratmaterial 2 | P-leistung 1: 0,17 W/cm² | 180 °C | Blasen |
| Vergleich | | P-druck 1: 0,09 mbar | | |

Das erfindungsgemäße Beispiel 1 zeigt, dass bei speziellen Drücken und speziellen Sputterenergien sehr gute Oberflächenqualitäten möglich sind. Demgegenüber gibt es Metallisierungsbedingungen die zu bei einem nachfolgenden Belastungstest zu Fehlern in der Oberfläche führen

### Beispiel 3 (Vergleich)

Das Substratmaterial 2 wird unter herkömmlichen Bedingungen zu Musterplatten verarbeitet - dabei wird nicht mit einer dynamischen Werkzeugtemperierung gearbeitet, d.h. es werden Musterplatten mit Seitenanguss in optischer Qualität angefertigt. Die Massetemperatur betrug 300 - 330 °C und die Werkzeugtemperatur 100 °C. Das Granulat wurde vor Verarbeitung für 5 Stunden im Vakuumtrockenschrank bei 120 °C getrocknet.

Das Formteil wurde dann wie in Beispiel 1 beschrieben metallisiert.

**Tabelle 2: Glanzmessung**

| Beispiel | Gloss 20° | Gloss 60° |
|---|---|---|
| 1 (Erfindungsgemäß) | 1449 | 784 |
| 3 (Vergleich) | 39 | 143 |

Man erkennt, dass das Formteil, welches nicht unter den für eine dynamische Werkzeugtemperierung angegebenen Bedingungen erzeugt wurde, keine hohen Glanzgrade (Gloss) aufweist. Dagegen zeigt das Beispiel 1 bei welchem mit einer dynamischen Werkzeugtemperierung (Werkzeugtemperatur nahe der Vicat-Erweichungstemperatur) gearbeitet wurde den Reflektoren benötigte hohen Glanzgrad (Gloss).

**Tabelle 3: Wärmeausdehnung**

| Beispiel | quer | längs |
|---|---|---|
| Substratmaterial 1 | 65,2 x10⁻⁶ /K | 65,2 x10⁻⁶ /K |
| Substratmaterial 2 | 52,4 x10⁻⁶ /K | 40,9 x10⁻⁶ /K |
| Substratmaterial 3 | 49,3 x 10⁻⁶/K | 36,8 x 10⁻⁶ /K |

Man erkennt, dass das zur Herstellung der erfindungsgemäßen Mehrschichtkörper dienende Substratmaterial 2 eine deutlich geringere Wärmeausdehnung aufweist.

**Tabelle 4: Schmelzestabilität**

| Beispiel | MVR (330 °C; 2,2 kg Auflagegewicht; 6 min Vorwärmzeit | IMVR (330 °C; 2,2 kg Auflagegewicht; 19 min Vorwärmzeit |
|---|---|---|
| Substratmaterial 1 | 8,0 cm³/[10 min] | |
| Substratmaterial 2 | 2,7 cm³/[10 min] | 3,0 cm³/[10 min] |
| Substratmaterial 3 | 59,8 cm³/[10 min] | 67,7 cm³/[10 min] |

Überraschenderweise zeigt das für die Erfindung geeignete Substratmaterial 2 einen deutlich höhere Schmelzestabilität im Vergleich zum Substratmaterial 3.

Insgesamt konnte gezeigt werden, dass nur das erfindungsgemäße Substratmaterial in Kombination mit der Abformung im Spritzgussoprozess mit dynamischer Werkzeugtemperierung und dem speziellen Beschichtungsverfahren zu den erfindungsgemäßen Mehrschichtkörpern führen.

## Patentansprüche

1. Mehrschichtkörper enthaltend mindestens eine Substratschicht, eine hiermit unmittelbar verbundene Metallschicht und wenigstens eine auf der Metallschicht aufliegende Schutzschicht, wobei die Substratschicht ein Copolycarbonat enthält das eine Vicat-Erweichungstemperatur von mehr als 160 °C gemäß- DIN ISO 306 aufweist, **dadurch gekennzeichnet, daß** die Substratschicht einen oder mehrere anorganische Füllstoffe mit sphärischer oder Plättchengeometrie zu 5 bis 50 Gew.-%, bezogen auf die die Summe eingesetzter Thermoplaste enthält,
wobei der Füllstoff ausgewählt ist aus der Gruppe bestehend aus Nitriden, Oxiden, Mischoxiden, Carbiden, gepulvertem Quarz, SiO₂-Partikeln, amorphem SiO₂, gemahlenem Sand, Glaspartikeln, Glasvollkugeln und synthetischem Graphit.

2. Mehrschichtkörper nach Anspruch 1, **dadurch gekennzeichnet, dass** das Copolycarbonat der Substratschicht mindestens einen Bisphenolbaustein der Formel (2) enthält, 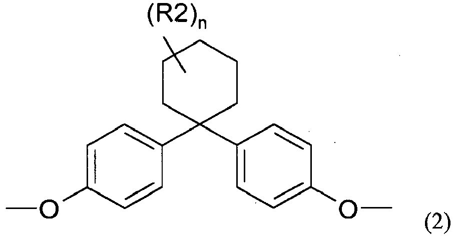 in der
R2 für C1-C4-Alkyl,
n für 0, 1, 2 oder 3,
sowie als Endgruppe (Kettenabbrecher) eine Struktureinheit der Formel (1) enthält 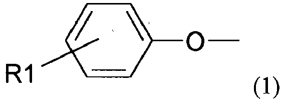 in der
R1 für Wasserstoff oder C1-C18-Alkyl , bevorzugt für C1 bis C18 Alkyl und besonders bevorzugt für tert.-butyl stehen.

3. Mehrschichtkörper nach Anspruch 1 oder 2 **dadurch gekennzeichnet, dass** 15 Gew.-% bis 95 Gew.-% insbesondere bevorzugt 25 Gew.-% bis 90 Gew.-% bezogen auf die Gesamtmenge der Bisphenol-blöcken, aus von 1,1-Bis-(4-hydroxyphenyl)-3,3,5-trimethylcyclohexan abgeleiteten Bisphenolblöcken besteht.

4. Mehrschichtkörper nach einem der Ansprüche 1 bis 3, **dadurch gekennzeichnet, dass** die Substratschicht neben dem Copolycarbonat einen weiteren thermoplastischen Kunstsstoff ausgewählt aus der Gruppe bestehend aus Polysulfon, Polyethersulfon, Polyetherimid enthält.

5. Mehrschichtkörper nach Anspruch 1, **dadurch gekennzeichnet, dass** plättchenförmiges Graphit mit einer kleinste Dimension (Dicke) geringer als 1 µm ist, oder Glaskugeln mit einem Durchmesser von 4 µm bis 120 µm oder Quarzpartikel mit einem Partikelgröße von D50% 0,1µm - 100µm oder Mischungen daraus.

6. Mehrschichtkörper nach einem der Ansprüche 1 bis 5 wobei die Substratschicht eine Dicke von 0,1 mm bis 6,0 mm, die Metallschicht eine Dicke von 10 nm - 1000 nm sowie eine Schutzschicht mit einer Dicke im Bereich von 5nm bis 200nm aufweist.

7. Mehrschichtkörper nach einem der Ansprüche 1 bis 6, wobei die Metallschicht eine Aluminium oder Silberschicht ist.

8. Mehrschichtkörper nach einem der Ansprüche 1 bis 7 wobei der Mehrschichtkörper zusätzlich eine Schutzschicht bestehend aus Siloxanen einer Dicke von 5 nm - 200 nm enthält.

9. Mehrschichtkörper nach einem der Ansprüche 1 bis 8 zur Herstellung von Lampenfassungen und -abdeckungen, Lichtsammelsystemen und -reflektoren, Kollimatoren, Leuchtdioden, bedampfte Displays und Scheiben, Linsenhalterungen, Lichtleiteriemente, LED-Applikationen (Sockel, LED-Reflektoren, heat sinks), Automobilteile wie Scheinwerfer, Bezels, Blinker, Reflektoren, und Solar-Reflektoren

10. Verfahren zur Herstellung eines Mehrschichtkörpers nach Anspruch 1 bis 9 **dadurch gekennzeichnet, dass** die Basisschicht durch Spritzgießen oder Extrusion gebildet wird und in einem darauffolgenden Schicht eine Metallschicht in einem Plasma-Verfahren aufgebracht wird.

11. Verfahren nach Anspruch 10, **dadurch gekennzeichnet, dass** die Plasmavorbehandlung mit einer Mittelfrequenzanregung mit einem Luft- oder Argon-basierten Plasma bei einer Frequenz von 0 Hz - 10 Mhz bei einer Leistung von 0.8W/cm2 - 8.3 W/cm2 sowie einem Prozessgasdruck von 0,04 bis 0,15 mbar erfolgt.

12. Verfahren nach Anspruch 10 oder 11 **dadurch gekennzeichnet, dass** die Substratschicht in einem Spritzgussprozess geformt wird, in welchem mit einer dynamischen Werkzeugtemperierung gearbeitet wird und die Werkzeugtemperatur beim Einspritzen +/- 20°C der Vicat-Erweichungstemperatur des verwendeten Substratmaterials beträgt.

## Claims

1. Multilayer structure comprising at least one substrate layer, one metal layer bonded directly thereto and at least one protective layer on the metal layer, wherein the substrate layer comprises a copolycarbonate which has a Vicat softening point above 160°C in accordance with DIN ISO 306, **characterized in that** the substrate layer comprises one or more inorganic fillers with spherical or lamellar geometry in an amount of from 5 to 50% by weight, based on the entirety of thermoplastics used, wherein the filler is one selected from the group consisting of nitrides, oxides, mixed oxides, carbides, powdered quartz, SiO₂ particles, amorphous SiO₂, ground sand, glass particles, solid glass beads and synthetic graphite.

2. Multilayer structure according to Claim 1, **characterized in that** the copolycarbonate of the substrate layer comprises at least one bisphenol unit of the formula (2), 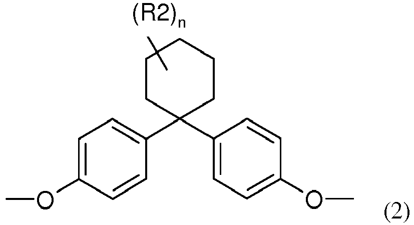 in which
R2 is C1-C4-alkyl,
n is 0, 1, 2 or 3,
and also comprises, as terminal group (chain terminator), a structural unit of the formula (1) 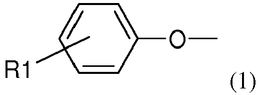 in which
R1 are hydrogen or C1-C18-alkyl, preferably C1-C18 alkyl and particularly preferably tert-butyl.

3. Multilayer structure according to Claim 1 or 2, **characterized in that**, based on the entire amount of the bisphenol blocks, from 15% by weight to 95% by weight, with particular preference from 25% by weight to 90% by weight, is composed of bisphenol blocks derived from 1,1-bis(4-hydroxyphenyl)-3,3,5-trimethylcyclohexane.

4. Multilayer structure according to any of Claims 1 to 3, **characterized in that** the substrate layer comprises, alongside the copolycarbonate, another thermoplastic selected from the group consisting of polysulphone, polyether sulphone, polyetherimide.

5. Multilayer structure according to Claim 1, **characterized in that** lamellar graphite is with a smallest dimension (thickness) smaller than 1 µm, or glass beads with a diameter of from 4 µm to 120 µm or quartz particles with a D50% particle size of from 0.1 µm to 100 µm or a mixture thereof.

6. Multilayer structure according to any of Claims 1 to 5, where the substrate layer has a thickness of from 0.1 mm to 6.0 mm, and the metal layer has a thickness of from 10 nm to 1000 nm, and also has a protective layer with a thickness in the range from 5 nm to 200 nm.

7. Multilayer structure according to any of Claims 1 to 6, where the metal layer is an aluminium or silver layer.

8. Multilayer structure according to any of Claims 1 to 7, where the multilayer structure also comprises a protective layer composed of siloxanes with a thickness of from 5 nm to 200 nm.

9. Multilayer structure according to any of Claims 1 to 8 for producing lamp holders and lamp covers, light-collector systems and light reflectors, collimators, light-emitting diodes, metallized displays and windshields, lens holders, optical-waveguide elements, LED applications (sockets, LED reflectors, heat sinks), automobile parts, such as headlamps, bezels, indicators, reflectors, and solar reflectors.

10. Process for producing a multilayer structure according to any of Claims 1 to 9, **characterized in that** the base layer is formed by injection moulding or extrusion and, in a subsequent layer, a metal layer is applied in a plasma process.

11. Process according to Claim 10, **characterized in that** the plasma pretreatment uses medium-frequency excitation with an air- or argon-based plasma at a frequency of from 0 Hz to 10 MHz at a power rating of from 0.8 W/cm² to 8.3 W/cm², and a process gas pressure of from 0.04 to 0.15 mbar.

12. Process according to Claim 10 or 11, **characterized in that** the substrate layer is moulded in an injection-moulding process which uses dynamic mould-temperature control and the mould temperature on injection is within +/-20°C of the Vicat softening point of the substrate material used.

## Revendications

1. Corps multicouche contenant au moins une couche de substrat, une couche métallique reliée directement avec celle-ci et au moins une couche de protection sus-jacente à la couche métallique, la couche de substrat contenant un copolycarbonate qui présente une température de ramollissement de Vicat de plus de 160 °C selon DIN ISO 306, **caractérisé en ce que** la couche de substrat contient une ou plusieurs charges inorganiques de géométrie sphérique ou plaquettaire à hauteur de 5 à 50 % en poids, par rapport à la somme des thermoplastiques utilisés,
la charge étant choisie dans le groupe constitué par les nitrures, les oxydes, les oxydes mixtes, les carbures, le quartz pulvérisé, les particules de SiO₂, le SiO₂ amorphe, le sable broyé, les particules de verre, les billes de verre pleines et le graphite synthétique.

2. Corps multicouche selon la revendication 1, **caractérisé en ce que** le copolycarbonate de la couche de substrat contient au moins un constituant bisphénol de formule (2) 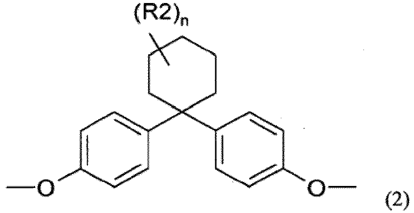 dans laquelle
R2 représente alkyle en C1-C4,
n représente 0, 1, 2 ou 3,
et contient en tant que groupe terminal (terminateur de chaîne) une unité structurale de formule (1) 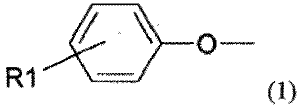 dans laquelle
R1 représente hydrogène ou alkyle en C1-C18, de préférence alkyle en C1 à C18 et de manière particulièrement préférée tert.-butyle.

3. Corps multicouche selon la revendication 1 ou 2, **caractérisé en ce que** 15 % en poids à 95 % en poids, de manière particulièrement préférée 25 % en poids à 90 % en poids, de la quantité totale des séquences bisphénol sont constituées de séquences bisphénol dérivées de 1,1-bis-(4-hydroxyphényl)-3,3,5-triméthylcyclohexane.

4. Corps multicouche selon l'une quelconque des revendications 1 à 3, **caractérisé en ce que** la couche de substrat contient en plus du copolycarbonate un autre plastique thermoplastique choisi dans le groupe constitué par la polysulfone, la polyéther-sulfone, le polyéther-imide.

5. Corps multicouche selon la revendication 1, **caractérisé en ce que** le graphite plaquettaire est avec une dimension la plus petite (épaisseur) inférieure à 1 µm ou des billes de verre ayant un diamètre de 4 µm à 120 µm ou des particules de quartz ayant une taille de particule D50% de 0,1 µm à 100 µm ou leurs mélanges.

6. Corps multicouche selon l'une quelconque des revendications 1 à 5, dans lequel la couche de substrat présente une épaisseur de 0,1 mm à 6,0 mm, la couche métallique une épaisseur de 10 nm à 1 000 nm, et une couche de protection une épaisseur dans la plage allant de 5 nm à 200 nm.

7. Corps multicouche selon l'une quelconque des revendications 1 à 6, dans lequel la couche métallique est une couche d'aluminium ou d'argent.

8. Corps multicouche selon l'une quelconque des revendications 1 à 7, dans lequel le corps multicouche contient en outre une couche de protection constituée de siloxanes d'une épaisseur de 5 nm à 200 nm.

9. Corps multicouche selon l'une quelconque des revendications 1 à 8, pour la fabrication de montures et de couvercles de lampes, de systèmes de recueillement et de réflecteurs de lumière, de collimateurs, de diodes luminescentes, d'écrans et de plaques métallisés, de supports de lentilles, d'éléments conducteurs de lumière, d'applications de LED (prises de courant, réflecteurs LED, pièges thermiques), de parties automobiles telles que des phares, des lunettes, des feux clignotants, des réflecteurs et des réflecteurs solaires.

10. Procédé de fabrication d'un corps multicouche selon les revendications 1 à 9, **caractérisé en ce que** la couche de base est formée par moulage par injection ou extrusion, et une couche métallique est appliquée par un procédé plasma dans une couche ultérieure.

11. Procédé selon la revendication 10, **caractérisé en ce que** le prétraitement plasma a lieu avec une excitation à fréquence moyenne avec un plasma à base d'air ou d'argon à une fréquence de 0 Hz à 10 MHz à une puissance de 0,8 W/cm² à 8,3 W/cm², et à une pression du gaz de procédé de 0,04 à 0,15 mbar.

12. Procédé selon la revendication 10 ou 11, **caractérisé en ce que** la couche de substrat est formée par un procédé de moulage par injection, lors duquel une régulation dynamique de la température de l'outil est utilisée, et la température de l'outil lors de l'injection est de ± 20 °C de la température de ramollissement de Vicat du matériau de substrat utilisé.
